# EUROPÄISCHE PATENTSCHRIFT

(11) **EP 0 484 566 B1**
(45) Veröffentlichungstag und Bekanntmachung des Hinweises auf die Patenterteilung: **25.01.1995**
(21) Anmeldenummer: 90121132.6
(22) Anmeldetag: 05.11.1990
(51) Int. Cl.: H03K 17/94, G01S 7/52

(54) **Automatische Sensorkennung bei Ultraschall-Näherungsschaltern**
Automatic sensor recognition for use in ultrasound proximity
Reconnaissance automatique de capteur pour commutateurs de proximité

(43) Veröffentlichungstag der Anmeldung: 13.05.1992
(73) Patentinhaber: SIEMENS AKTIENGESELLSCHAFT, 80333 München (DE)
(72) Erfinder: Forster, Alfred, Dipl.-Ing. FH, W-8460 Schwandorf (DE); Schwarz, Robert, Dipl.-Ing. FH, W-8451 Freudenberg (DE)

(56) Entgegenhaltungen:
- EP-A- 0 249 952
- DE-A- 2 541 901
- DE-A- 3 703 658
- PATENT ABSTRACTS OF JAPAN vol. 6, no. 34 (P-104)(912) 02 März 1982, & JP-A-56 151371 (MATSUSHITA) 24 November 1981

## Beschreibung

Die Erfindung betrifft einen Ultraschall-Näherungsschalter mit einer Auswerteelektronik, einem unter unterschiedlichen Sensortypen wählbaren Sensor und einem Oszillator, der mit einer Oszillatorfrequenz schwingt und dessen Ausgangsimpulse zur Erzeugung eines Sendeimpulses dienen.

Ein derartiger Ultraschall-Näherungsschalter ist bereits bekannt (siehe Patent Abstracts of Japan, vol. 6, no. 34 (P104) (912) 02.03.1982 & JP-A-56 151371). Zur Messung der Temperatur des umgebenden Mediums wird hier mittels eines monostabilen Multivibrators, dessen Zeitglied einen Heißleiter enthalt, ein temperaturabhängiger Impuls erzeugt. Dieser wird von einer Auswerteschaltung ausgewertet.

Bei ebenfalls bekannten Ultraschall-Näherungsschaltern erfolgt die Auswertung des empfangenen Echos üblicherweise in einer örtlich getrennten Auswerteelektronik. Um einen Betrieb mit unterschiedlichen Sensorausführungen der Ultraschall-Näherungsschalter zu ermöglichen, müssen die Auswerteparameter in der Auswerteelektronik an den jeweilig verwendeten Sensortyp angepaßt werden. Zur Vermeidung von Fehlern erfolgt vorteilhafterweise die Umschaltung beim Anschließen eines neuen Sensortyps automatisch. Die Sensorkennung wurde bisher z.B. durch manuelle Kodierung oder unterschiedliche Spannungspegel realisiert, die einem Sensorausgangssignal während genau definierter Zeitspannen aufgekoppelt wurden (siehe Patentschrift DE 34 28 773 (2). Je mehr Sensoren allerdings zur Anwendung kommen und damit zu unterscheiden sind, desto aufwendiger und störanfälliger wird diese Art der Sensorkennung.

Daher besteht die Aufgabe der Erfindung darin, einen Ultraschall-Näherungsschalter zu schaffen, der hinsichtlich Einfachheit und Sicherheit der Sensorkennung verbessert ist. Dies wird auf einfache Art und Weise dadurch erreicht, daß die Oszillatorfrequenz mit der Sendefrequenz des eingesetzten Sensortyps übereinstimmt, daß ein Zähler vorgesehen ist, dem die Ausgangsimpulse des Oszillators zugeführt werden, um das Ende eines ersten zur Erkennung des Sensortyps dienenden und am Ende eines dem Zähler zugeführten Sendetaktsignals beginnenden Impulses mit einer ersten Impulsdauer zu bestimmen, welche dem Produkt aus einem eingestellten Zählerstand und der Impulslänge der Ausgangsimpulse des Oszillators entspricht. Außerdem ist es in Verbindung mit den genannten Merkmalen zur Lösung erforderlich, daß der erste Impuls der Auswerteelektronik zugeführt wird, um eine Kennung des Sensortyps und eine Anpassung der Auswerteparameter der Auswerteelektronik zu ermöglichen. Es erweist sich als vorteilhaft, wenn die Ausgangsimpulse des Oszillators durch einen Sendetakt periodisch auf eine Sendestufe schaltbar sind und wenn der erste Impuls durch den Sendetakt synchronisierbar ist. Weiterhin ist es vorteilhaft, wenn eine Einrichtung vorhanden ist, die bei Flankenwechsel des Sendetaktes den Zähler und damit den ersten Impuls startet und wenn durch das Ende des ersten Impulses ein dem Zähler nachgeschaltetes Monoflop triggerbar ist, das ein erstes Signal mit dem zweiten Impuls von einer einer physikalischen Meßgröße entsprechenden zweiten Impulsdauer an seinem Ausgang erzeugt. Zur Kompensation des Einflusses der Umgebungstemperatur auf die Echolaufzeiten ist es zweckmäßig, wenn das Monoflop mit einer Temperaturerfassungseinrichtung beschaltet ist und die zweite Impulsdauer die gemessene Temperatur des umgebenden Mediums repräsentiert. Eine besonders einfache Ausgestaltung besteht, wenn der Zähler Bestandteil eines integrierten Schaltkreises ist, der den Oszillator aufweist. Ist das Monoflop mit der Temperaturerfassungseinrichtung mindestens teilweise Bestandteil des integrierten Schaltkreises, so läßt sich hiermit der Aufwand an zusätzlichen Bauteilen und Kosten reduzieren. Um unnötig viele Signalübertragungsleitungen vom Ultraschall-Näherungsschalter zur Auswerteelektronik zu vermeiden, ist es außerdem vorteilhaft, wenn ein zweites Signal sowohl den ersten Impuls mit der ersten Impulsdauer als auch den zweiten Impuls mit der zweiten Impulsdauer aufweist.

Eine Ausführungsform der Erfindung wird anhand der folgenden Zeichnung näher erläutert. Es zeigen
- FIG 1: eine Schaltung zur verbesserten Sensorkennung
- FIG 2: ein Impulsdiagramm.

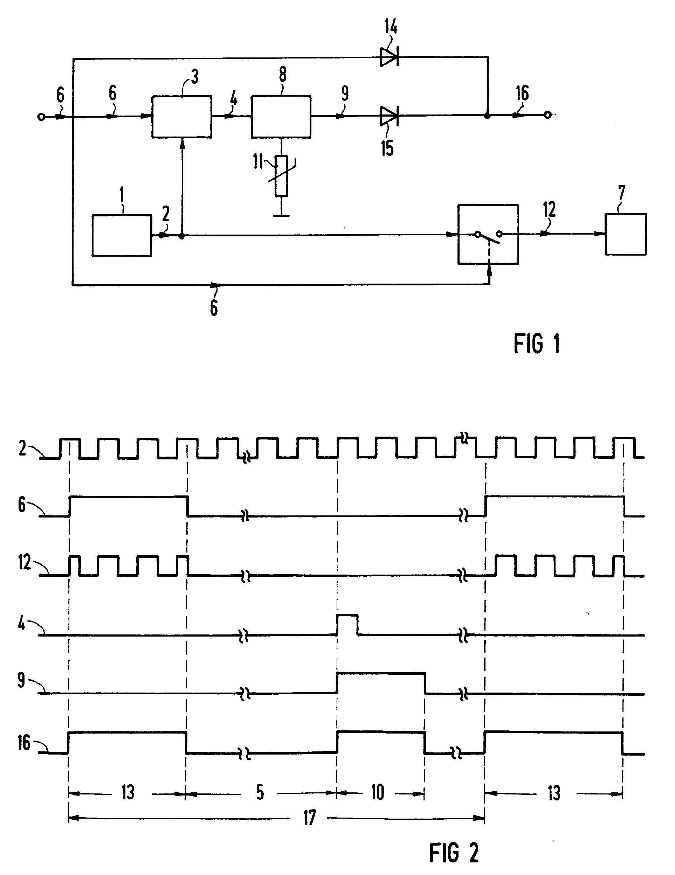

In FIG 1 ist ein Oszillator 1 dargestellt, dessen Oszillatorfrequenz 2 auf eine Sendestufe 7 entsprechend einem vorgegebenen Sendetakt 6 aufgeschaltet wird. Einem Zähler 3 wird die Oszillatorfrequenz 2 vom freischwingenden Oszillator 1 zugeführt. Der Sendetakt 6 startet den Zähler 3 über eine ihm vorgeschaltete Einrichtung. Der Ausgang des Zählers 3 ist mit einem Monoflop 8 verbunden, das mit einer Temperaturerfassungseinrichtung, hier mit einem Heißleiter 11, beschaltet ist. Zur Erläuterung dieser Schaltung sei auf das Impulsdiagramm gemäß FIG 2 verwiesen. Hier ist die Oszillatorfrequenz 2 abgebildet, die durch den Sendetakt 6 getaktet einen Sendeimpuls 12 liefert, der der Sendestufe 7 zugeführt wird. Der Sendeimpuls 12 beinhaltet eine Sendezeit 13, die sich periodisch nach einer Taktzeit 17 wiederholt. Durch den Flankenwechsel am Ende der Sendezeit 13 wird über die hier nicht dargestellte Einrichtung der Zähler 3 gestartet, womit der erste Impuls mit der Impulsdauer 5 zu laufen beginnt. Gemäß dem eingestellten Zählerstand zählt der Zähler 3 die Impulse der ihm zugeführten Oszillatorfrequenz 2. Bei Erreichen des Zählerstandes, d.h. am Ende der ersten Impulsdauer 5 wird durch den Flankenwechsel des ersten Impulses das Monoflop 8 getriggert. Am Ausgang des Zähler 3 steht ein Signal 4 gemäß FIG 2 an. Durch den Triggerimpuls wird ein dritter Impuls mit der zweiten Impulsdauer 10 eingeleitet, wobei letzter der von der Temperaturerfassungseinrichtung mit Hilfe des Heißleiters 11 gemessenen Lufttemperatur entspricht. Am Ausgang des Monoflops 8 steht ein Signal 9 gemäß FIG 2 an, das die Information über die Lufttemperatur beinhaltet. Über die beiden Dioden 14 und 15 wird der Sendetakt 6 mit dem Ausgang des Monoflops 8, entsprechend Signal 9, zu einem dritten Signal 16 verknüpft. Dieses dritte Signal 16 beinhaltet die Information sowohl über die Oszillatorfrequenz durch die erste Impulsdauer 5 als auch die Lufttemperatur durch den dritten Impuls mit der zweiten Impulsdauer 10. In Anwendungsfällen, in denen der Oszillator 1 und die Beschaltung für die Lufttemperaturerfassung 8, 11 bereits auf einem Schaltkreis integriert sind, bietet die Aufnahme eines weiteren Zählers auf dem integrierten Schaltkreis gemäß der vorbeschriebenen Schaltung eine einfache und kostengünstige Lösung zur zusätzlichen Sensorkennung.

## Patentansprüche

1. Ultraschall-Näherungsschalter mit einer Auswerteelektronik, einem unter unterschiedlichen Sensortypen wählbaren Sensor und einem Oszillator (1), der mit einer Oszillatorfrequenz schwingt und dessen Ausgangsimpulse (2) zur Erzeugung eines Sendeimpulses (12) dient, **dadurch gekennzeichnet**, daß die Oszillatorfrequenz des Oszillators (1) mit der Sendefrequenz des eingesetzten Sensortyps übereinstimmt, daß ein Zähler (3) vorgesehen ist, dem die Ausgangsimpulse (2) des Oszillators (1) zugeführt werden, um das Ende eines ersten zur Erkennung des Sensortyps dienenden und am Ende eines dem Zähler (3) zugeführten Sendetaktsignals (6) beginnenden Impulses mit einer ersten Impulsdauer (5) zu bestimmen, welche dem Produkt aus einem eingestellten Zählerstand und der Impulslänge der Ausgangsimpulse (2) des Oszillators (1) entspricht; daß der erste Impuls der Auswerteelektronik zugeführt wird, um eine Kennung des Sensortyps und eine Anpassung der Auswerteparameter der Auswerteelektronik zu ermöglichen.

2. Ultraschall-Näherungsschalter nach Anspruch 1,
**dadurch gekennzeichnet**, daß die Ausgangsimpulse (2) des Oszillators (1) durch einen Sendetakt (6) periodisch auf eine Sendestufe (7) schaltbar sind und daß der erste Impuls durch den Sendetakt (6) synchronisierbar ist.

3. Ultraschall-Näherungsschalter nach Anspruch 1 oder 2,
**dadurch gekennzeichnet**, daß eine Einrichtung vorhanden ist, die bei Flankenwechsel des Sendetakts (6) den Zähler (3) und damit den ersten Impuls startet und daß durch das Ende des ersten Impulses ein dem Zähler (3) nachgeschaltetes Monoflop (8) triggerbar ist, das ein erstes Signal (9) mit einem zweiten Impuls von einer physikalischen Meßgröße entsprechenden zweiten Impulsdauer (10) an seinem Ausgang erzeugt.

4. Ultraschall-Näherungsschalter nach Anspruch 3,
**dadurch gekennzeichnet**, daß das Monoflop (8) mit einer Temperaturerfassungseinrichtung (11) beschaltet ist und die zweite Impulsdauer (10) die gemessene Temperatur des umgebenden Mediums repräsentiert.

5. Ultraschall-Näherungsschalter nach einem der oben genannten Ansprüche, **dadurch gekennzeichnet**, daß der Zähler (3) Bestandteil eines integrierten Schaltkreises ist, der den Oszillator (1) aufweist.

6. Ultraschall-Näherungsschalter nach einem der Ansprüche 3-5, **dadurch gekennzeichnet**, daß das Monoflop (8) mit der Temperaturerfassungseinrichtung (11) mindestens teilweise Bestandteil des integrierten Schaltkreises ist.

7. Ultraschall-Näherungsschalter nach einem der Ansprüche 3-6, **dadurch gekennzeichnet**, daß ein zweites Signal (16) sowohl den ersten Impuls mit der ersten Impulsdauer (5) als auch den zweiten Impuls mit der zweiten Impulsdauer (10) aufweist.

## Claims

1. An ultrasonic proximity switch with evaluation electronics, a sensor selectable from different sensor types and an oscillator (1), which oscillates with an oscillator frequency and whose outlet pulses (2) are used for generating a transmission pulse (12), characterised in that the oscillator frequency of the oscillator (1) corresponds to the transmission frequency of the type of sensor used, in that a counter (3) is provided, to which the output pulses (2) of the oscillator (1) are supplied in order to determine the end of a first pulse, which is used for recognising the sensor type, begins at the end of a transmitting clock signal (6) supplied to the counter (3) and has a first pulse duration (5) which corresponds to the product of the pre-set counter content and the pulse length of the output signal (2) of the oscillator (1); in that the first pulse is supplied to the evaluation electronics in order to allow for a recognition of the sensor type and an adaptation of the evaluation parameters of the evaluation electronics.

2. An ultrasonic proximity switch according to claim 1, characterised in that the output pulses (2) of the oscillator (1) can be periodically switched to a transmitting stage (7) and the first pulse can be synchronised by the transmitting clock pulse (6).

3. An ultrasonic proximity switch according to claim 1 or 2, characterised in that a device is provided, which starts the counter (3) and consequently the first pulse when the transmitting clock pulse (6) has a change state, and a monoflop (8) which is connected to the output side of the counter (3) can be triggered by the end of the first pulse, a first signal (9) with a second pulse of a second pulse duration (10) corresponding to a physical measured variable being generated at the output of the monoflop (8).

4. An ultrasonic proximity switch according to claim 3, characterised in that the monoflop (8) is wired to a temperature-sensing device (11), and the second pulse duration (10) represents the measured temperature of the surrounding medium.

5. An ultrasonic proximity switch according to one of the preceding claims, characterised in that the counter (3) is a component of an integrated circuit which includes the oscillator (1).

6. An ultrasonic proximity switch according to one of claims 3 to 5, characterised in that the monoflop (8) with the temperature-sensing device (11) is at least partially a component of the integrated circuit.

7. An ultrasonic proximity switch according to one of claims 3 to 6, characterised in that a second signal (16) produces both the first pulse with the first pulse duration (5) and the second pulse with the second pulse duration (10).

## Revendications

1. Interrupteur de proximité à ultrasons comportant un système électronique d'évaluation, un capteur pouvant être sélectionné parmi différents types de capteurs, et un oscillateur (1), qui oscille avec une fréquence d'oscillation et dont les impulsions de sortie (2) servent à produire une impulsion d'émission (12), caractérisé par le fait que la fréquence d'oscillation de l'oscillateur (1) coïncide avec la fréquence d'émission du type de capteur utilisé, qu'il est prévu un compteur (3), auquel les impulsions de sortie (2) de l'oscillateur (1) sont envoyées de manière à déterminer la fin d'une première impulsion utilisée pour identifier le type de capteur et qui commence à la fin d'un signal de cadence d'émission (6) envoyé au compteur (3) et possède une première durée (5), qui correspond au produit d'un état de comptage réglé du compteur par la durée des impulsions de sortie (2) de l'oscillateur (1); et que la première impulsion est envoyée au système électronique d'évaluation pour permettre une caractérisation du type de capteur et une adaptation des paramètres d'évaluation du système électronique d'évaluation.

2. Interrupteur de proximité à ultrasons suivant la revendication 1, caractérisé par le fait que les impulsions de sortie (2) de l'oscillateur (1) peuvent être appliquées périodiquement, conformément à une cadence d'émission (6), à un étage d'émission (7), et que la première impulsion peut être synchronisée par la cadence d'émission (6).

3. Interrupteur de proximité à ultrasons suivant l'une des revendications 1 ou 2, caractérisé par le fait qu'il est prévu un dispositif, qui, dans le cas du changement de flanc de la cadence d'émission (6), déclenche le compteur (3) et par conséquent la première impulsion et que la fin de la première impulsion déclenche un multivibrateur monostable (8), qui est branché en aval du compteur (3) et qui produit à sa sortie une seconde impulsion possédant une seconde durée (10) qui correspond à une grandeur de mesure physique.

4. Interrupteur de proximité à ultrasons suivant la revendication 3, caractérisé par le fait que le multivibrateur monostable (8) est raccordé à un dispositif de détection de température (11) et que la seconde durée d'impulsions (10) représente la température mesurée du milieu environnant.

5. Interrupteur de proximité à ultrasons suivant une ou plusieurs des revendications indiquées précédemment, caractérisé par le fait que le compteur (3) fait partie d'un circuit intégré, qui comporte l'oscillateur (1).

6. Interrupteur de proximité à ultrasons suivant l'une des revendications 3 - 5, caractérisé par le fait que le multivibrateur monostable (8) équipé du dispositif de détection de température (11) fait partie, au moins partiellement, du circuit intégré.

7. Interrupteur de proximité à ultrasons suivant l'une des revendications 1 - 6, caractérisé par le fait qu'un second signal (7) comprend aussi bien la première impulsion possédant la première durée d'impulsion (6) que la seconde impulsion possédant la seconde durée d'impulsions (10).
